# EUROPEAN PATENT APPLICATION

(11) **EP 4 815 661 A1**
(43) Date of publication of application: **30.09.2026**
(21) Application number: 26151344.4
(22) Date of filing: 12.01.2026
(51) Int. Cl.: H10D 1/68, H10D 1/00, H10B 12/00

(54) **SEMICONDUCTOR STRUCTURE AND FORMING METHOD THEREOF**

(30) Priority: 28.03.2025 CN 202510377902
(71) Applicant: SwaySure Technology Co., Ltd., Shenzhen (CN)
(72) Inventor: XIA, Jun, Shenzhen (CN); LAI, Kuo-Wen, Shenzhen (CN); WANG, Yichuan, Shenzhen (CN)
(74) Representative: IK-IP LTD

(57) **Abstract**

A semiconductor structure and a forming method thereof are provided. The structure includes: a substrate structure(402, 602) having a capacitor region(400A, 500A) and an adjacent logic region(400B, 500B), and including a first insulation layer(400) with a plurality of inlaid conductive portions(401, 601); a first etching stop layer(404, 504, 640) in the capacitor region(400A, 500A), at least covering a top of the conductive portion(401, 601); a second etching stop layer(405, 509) in the logic region(400B, 500B), covering a top of the first insulation layer(400), where the first and second etching stop layers are either made of a same material and separated by a protective layer(409, 609), or made of different materials with a contact interface therebetween; a first stacked structure(410, 510) over the first and second etching stop layers; and a slit opening(430, 530) extending through the first stacked structure(410, 510) and exposing the second etching stop layer(405, 509).

## Description

### TECHNICAL FIELD

Embodiments of the present disclosure relate to the field of semiconductor manufacturing, and in particular, to a semiconductor structure and a forming method thereof.

### BACKGROUND

With the rapid development of mobile consumer electronic products, users have higher requirements on device miniaturization, functional integration, and large-capacity storage. For example, devices such as smartphones and tablet computers need to be integrated with more functional modules, such as processors, memories, and sensors, within limited space while meeting user requirements on large-capacity storage. To achieve this objective, high-density packaging technology is crucial. However, conventional packaging methods are gradually facing bottlenecks in terms of space utilization and performance improvement, leading to various types of "misaligned" structures during the design process.

Currently, in the design of capacitor structures, an electrode column accommodating hole is formed on a structure in which silicon oxide layers and silicon nitride layers are alternately stacked. The center line of an electrode column prepared in the electrode column accommodating hole and the center line of the source and drain do not coincide, but are "misaligned". In the etching process of the electrode column accommodating hole, an aluminum oxide layer needs to be arranged as an etching stop layer. The bottom size of the electrode column accommodating hole shrinks on the etching stop layer and falls above a conductive portion. Then, a slit opening extending through the structure in which the silicon oxide layers and the silicon nitride layers are stacked is etched. Silicon nitride in the structure in which the silicon oxide layers and the silicon nitride layers are stacked structure is removed by pickling through the slit opening. In the pickling process, the acid comes into contact with the aluminum oxide etching stop layer and undergoes a chemical reaction, greatly increasing the probability of structural collapse of the semiconductor structure.

Therefore, reliability of the semiconductor structure still needs to be improved.

### SUMMARY

A solution to a problem to be resolved in embodiments of the present disclosure is to provide a semiconductor structure and a forming method thereof, to improve reliability of a semiconductor structure.

To resolve the foregoing problems, an embodiment of the present disclosure provides a semiconductor structure, including: a substrate structure, where the substrate structure has a capacitor region and a logic region adjacent to the capacitor region and includes a first insulation layer and a plurality of conductive portions inlaid at intervals in the first insulation layer, where the conductive portions are located in the capacitor region, and a top surface of the conductive portion is exposed from the first insulation layer; a first etching stop layer, located in the capacitor region and at least covering a top portion of the conductive portion; and a second etching stop layer, located in the logic region and covering a top portion of the first insulation layer, where the second etching stop layer and the first etching stop layer are located in a same layer, and top surfaces of the second etching stop layer and the first etching stop layer are flush, where the first etching stop layer and the second etching stop layer are made of a same material, and the first etching stop layer and the second etching stop layer are separated by a protective layer; or the first etching stop layer and the second etching stop layer are made of different materials, and a contact interface is formed between the first etching stop layer and the second etching stop layer; a first stacked structure, covering a layer in which the first etching stop layer and the second etching stop layer are located; a plurality of first electrode columns, where each first electrode column extends through the first stacked structure and the first etching stop layer and is in contact with and connected to a corresponding one of the conductive portions; and a slit opening, extending through the first stacked structure and exposing the second etching stop layer.

Correspondingly, an embodiment of the present disclosure further provides a semiconductor structure forming method, including: providing a substrate structure, where the substrate structure has a capacitor region and a logic region adjacent to the capacitor region and includes a first insulation layer and a plurality of conductive portions inlaid at intervals in the first insulation layer, the conductive portions are located in the capacitor region, and a top surface of the conductive portion is exposed from the first insulation layer; forming an etching stop structure on the substrate structure, where the etching stop structure includes: a first etching stop layer, located in the capacitor region and at least covering a top portion of the conductive portion; and a second etching stop layer, located in the logic region and covering a top portion of the first insulation layer, where the first etching stop layer and the second etching stop layer are located in a same layer, and top surfaces of the first etching stop layer and the second etching stop layer are flush, where the first etching stop layer and the second etching stop layer are made of a same material, and the first etching stop layer and the second etching stop layer are separated by a protective layer; or the first etching stop layer and the second etching stop layer are made of different materials, and a contact interface is formed between the first etching stop layer and the second etching stop layer; forming a first stacked structure on the etching stop structure; forming a plurality of first electrode column accommodating holes extending through the first stacked structure, where the first electrode column accommodating hole exposes the conductive portion; preparing a first electrode column in the first electrode column accommodating hole, where each of the first electrode columns is in contact with and connected to a corresponding one of the conductive portions; and forming a slit opening extending through the first stacked structure, where the second etching stop layer is exposed from the slit opening.

Compared with the related art, the technical solutions of the embodiments of the present disclosure have the following advantages:
According to the semiconductor structure and the forming method provided in the embodiments of the present disclosure, an etching stop layer structure is arranged as including a first etching stop layer and a second etching stop layer, and when the first etching stop layer and the second etching stop layer are made of the same material, the first etching stop layer and the second etching stop layer are separated by using a protective layer; or when the first etching stop layer and the second etching stop layer are made of different materials, a contact interface is formed between the first etching stop layer and the second etching stop layer. In a subsequent process of performing pickling on a first stacked structure through a slit opening, a pickling solution can also chemically react with the first etching stop layer. When the first etching stop layer and the second etching stop layer are made of the same material, the protective layer is arranged between the first etching stop layer and the second etching stop layer, so that the protective layer protects a side wall of the first etching stop layer in a capacitor region and reduces a probability of the pickling solution contacting the first etching stop layer, thereby reducing a probability of the first etching stop layer in the capacitor region being damaged; or when the first etching stop layer and the second etching stop layer are made of the different materials, a contact interface is formed between the first etching stop layer and the second etching stop layer, so that the second etching stop layer protects a side wall of the first etching stop layer in a capacitor region and reduces a probability of a pickling solution contacting the first etching stop layer in a subsequent pickling process, thereby reducing a probability of the first etching stop layer in the capacitor region being damaged and further improving reliability of the semiconductor structure.

### BRIEF DESCRIPTION OF THE DRAWINGS

FIG. 1 to FIG. 6 are schematic structural diagrams corresponding to steps of a semiconductor structure forming method;
FIG. 7 is a schematic structural diagram corresponding to a first embodiment of a semiconductor structure according to the present disclosure;
FIG. 8 is a schematic structural diagram corresponding to a second embodiment of a semiconductor structure according to the present disclosure;
FIG. 9 is a schematic structural diagram corresponding to a third embodiment of a semiconductor structure according to the present disclosure;
FIG. 10 to FIG. 18 are schematic structural diagrams corresponding to steps of a first embodiment of a semiconductor structure forming method according to the present disclosure;
FIG. 19 to FIG. 22 are schematic structural diagrams corresponding to steps of a second embodiment of a semiconductor structure forming method according to the present disclosure; and
FIG. 23 to FIG. 27 are schematic structural diagrams corresponding to steps of a third embodiment of a semiconductor structure forming method according to the present disclosure.

### DETAILED DESCRIPTION

Currently, reliability of a semiconductor structure still needs to be improved. With reference to a semiconductor structure forming method, a reason why performance of the semiconductor structure is to be improved is analyzed.

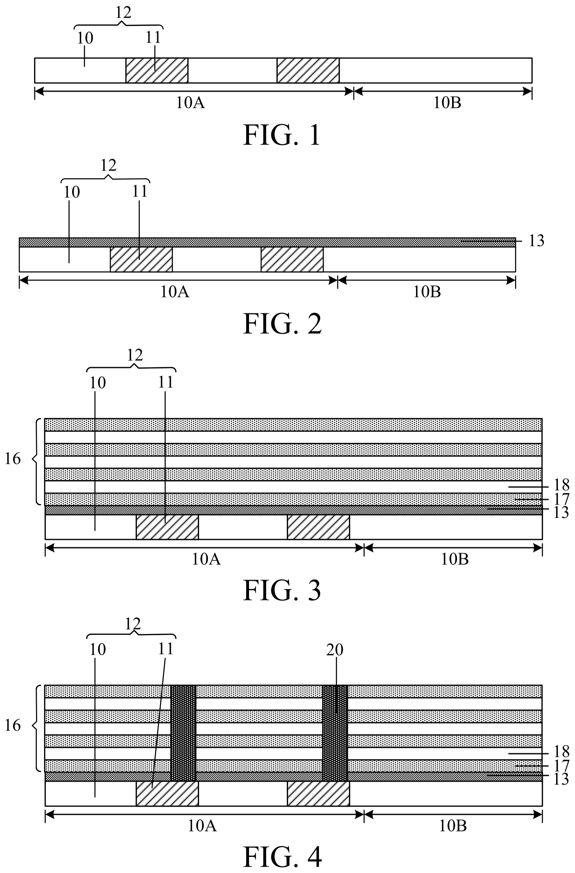

Referring to FIG. 1, a substrate structure 12 is provided, where the substrate structure 12 has a capacitor region 10A and a logic region 10B adjacent to the capacitor region 10A and includes a first insulation layer 10 and a plurality of conductive portions 11 inlaid at intervals in the first insulation layer 10, the conductive portions 11 are located in the capacitor region 10A, and a top surface of the conductive portion 11 is exposed from the first insulation layer 10.

Referring to FIG. 2, an etching stop layer 13 covering the first insulation layer 10 and the conductive portion 11 is formed on a top portion of the substrate structure 12 in the capacitor region 10A and the logic region 10B. A material of the etching stop layer 13 is aluminum oxide.

Referring to FIG. 3, a first stacked structure 16 is formed on the etching stop layer 13, the first stacked structure 16 includes silicon oxide layers 17 and silicon nitride layers 18 that are alternately deposited, and an uppermost layer of the first stacked structure 16 is a silicon oxide layer 17.

Referring to FIG. 4, a plurality of first electrode columns 20 embedded in and extending through the first stacked structure 16 and the etching stop layer 13 are formed in the capacitor region 10A, and each of the first electrode columns 20 is in contact with and connected to a corresponding one of the conductive portions 11.

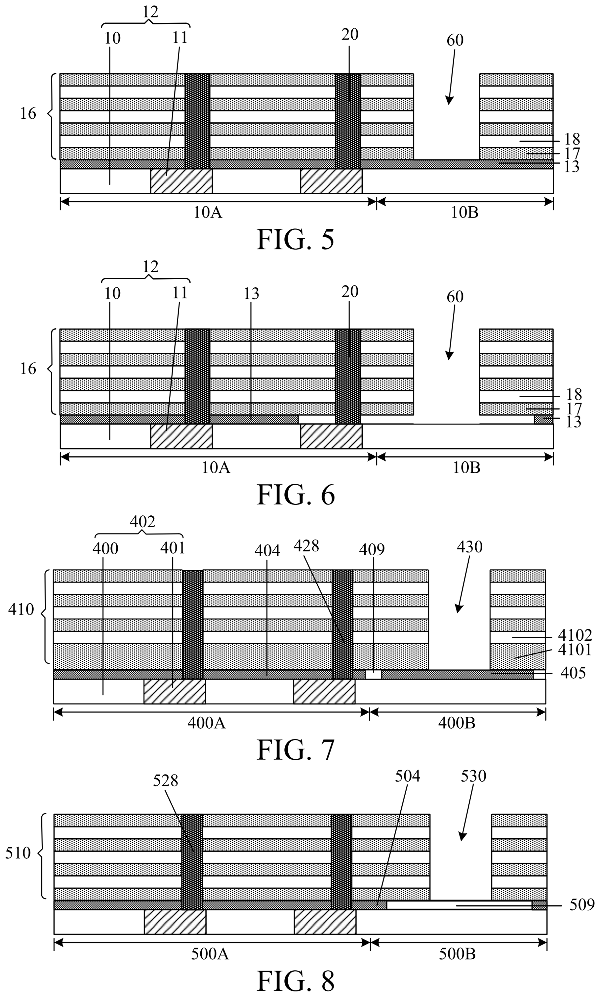

Referring to FIG. 5, a slit opening 60 extending through the first stacked structure 16 is formed in the logic region 10B, where the second etching stop layer 13 is exposed through the slit opening 60.

Referring to FIG. 6, the silicon nitride layer 18 is removed by pickling through the slit opening 60.

Research has found that in a subsequent process of removing the silicon nitride layer 18 by pickling through the slit opening 60, a pickling solution also chemically reacts with the aluminum oxide etching stop layer 13, causing the etching stop layer 13 in the capacitor region 10A to be hollowed out by the pickling solution (as shown in FIG. 6), which increases a risk of structural collapse of the semiconductor structure and affecting reliability of the semiconductor structure.

To resolve the foregoing problems, an embodiment of the present disclosure provides a semiconductor structure, including: a substrate structure, where the substrate structure has a capacitor region and a logic region adjacent to the capacitor region and includes a first insulation layer and a plurality of conductive portions inlaid at intervals in the first insulation layer, where the conductive portions are located in the capacitor region, and a top surface of the conductive portion is exposed from the first insulation layer; a first etching stop layer, located in the capacitor region and at least covering a top portion of the conductive portion; and a second etching stop layer, located in the logic region and covering a top portion of the first insulation layer, where the second etching stop layer and the first etching stop layer are located in a same layer, and top surfaces of the second etching stop layer and the first etching stop layer are flush, where the first etching stop layer and the second etching stop layer are made of a same material, and the first etching stop layer and the second etching stop layer are separated by a protective layer; or the first etching stop layer and the second etching stop layer are made of different materials, and a contact interface is formed between the first etching stop layer and the second etching stop layer; a first stacked structure, covering a layer in which the first etching stop layer and the second etching stop layer are located; a plurality of first electrode columns, where each first electrode column extends through the first stacked structure and the first etching stop layer and is in contact with and connected to a corresponding one of the conductive portions; and a slit opening, extending through the first stacked structure and exposing the second etching stop layer.

According to the semiconductor structure provided in the embodiments of the present disclosure, the first etching stop layer is located in the capacitor region and covers at least the top portion of the conductive portion. The second etching stop layer is located in the logic region and covers the top portion of the first insulation layer. The second etching stop layer and the first etching stop layer are located in the same layer and top surfaces of the second etching stop layer and the first etching stop layer are flush. The first etching stop layer and the second etching stop layer are made of the same material, and the first etching stop layer and the second etching stop layer are separated by the protective layer; or the first etching stop layer and the second etching stop layer are made of different materials, and a contact interface is formed between the first etching stop layer and the second etching stop layer. In a subsequent process of performing pickling on a first stacked structure through a slit opening, a pickling solution can also chemically react with the first etching stop layer. Therefore, when the first etching stop layer and the second etching stop layer are made of the same material, the protective layer is arranged between the first etching stop layer and the second etching stop layer, so that the protective layer protects a side wall of the first etching stop layer in a capacitor region, reduces a probability of the pickling solution contacting the first etching stop layer, thereby reducing a probability of the first etching stop layer in the capacitor region being damaged; or when the first etching stop layer and the second etching stop layer are made of the different materials, a contact interface is formed between the first etching stop layer and the second etching stop layer, so that the second etching stop layer protects a side wall of the first etching stop layer in a capacitor region and reduces a probability of a pickling solution contacting the first etching stop layer in a subsequent pickling process, thereby reducing a probability of the first etching stop layer in the capacitor region being damaged and further improving reliability of the semiconductor structure.

To make the foregoing objectives, features, and advantages of the embodiments of the present disclosure more obvious and comprehensible, specific embodiments of the present disclosure are described in detail below with reference to the accompanying drawings. FIG. 7 is a schematic structural diagram corresponding to a first embodiment of a semiconductor structure according to the present disclosure.

The semiconductor structure includes: a substrate structure 402, where the substrate structure 402 has a capacitor region 400A and a logic region 400B adjacent to the capacitor region 400A and includes a first insulation layer 400 and a plurality of conductive portions 401 inlaid at intervals in the first insulation layer 400, where the conductive portions 401 are located in the capacitor region 400A, and the first insulation layer 400 exposes a top surface of the conductive portion 401; a first etching stop layer 404, located in the capacitor region 400A and at least covering a top portion of the conductive portion 401; a second etching stop layer 405, located in the logic region 400B and covers a top portion of the first insulation layer 400, where the second etching stop layer 405 and the first etching stop layer 404 are located in a same layer, and top surfaces of the second etching stop layer 405 and the first etching stop layer 404 are flush, where the first etching stop layer 404 and the second etching stop layer 405 are made of a same material, and the first etching stop layer 404 and the second etching stop layer 405 are separated by a protective layer 409; a first stacked structure 410, covering a layer in which the first etching stop layer 404 and the second etching stop layer 405 are located; a plurality of first electrode columns 428, where each first electrode column 428 extends through the first stacked structure 410 and the first etching stop layer 404 and is in contact with and connected to a corresponding conductive portion 401; and a slit opening 430, extending through the first stacked structure 410 exposing the second etching stop layer 405.

Specifically, in a subsequent process of perform pickling on the first stacked structure 410 through the slit opening 430, the pickling solution may also chemically react with the first etching stop layer 404 and the second etching stop layer 405. Therefore, a protective layer 409 is arranged between the first etching stop layer 404 and the second etching stop layer 405, so that the protective layer 409 protects a sidewall of the first etching stop layer 404 of the capacitor region 400A, thereby reducing a probability of the pickling solution contacting the first etching stop layer 404. In this way, a probability of the first etching stop layer 404 of the capacitor region 400A being damaged is reduced, and a risk of collapse of the semiconductor structure due to damage to the first etching stop layer 404 of the capacitor region 400A is reduced, thereby improving the reliability of the semiconductor structure.

Specifically, the substrate structure 402 provides a process platform for the semiconductor structure forming method.

In an example, the semiconductor structure is a capacitor structure.

In the capacitor structure, the capacitor region 400A is used as a region for storing data, and the logic region 400B is used as a region for controlling data read and write operations.

It should be noted that the first insulation layer 400 is configured to electrically separate adjacent conductive portions 401.

The first insulation layer 400 exposes the top surface of the conductive portion 401. During subsequent formation of the first electrode column 428, the first electrode column 428 extends through the subsequently formed first stacked structure 410 and the first etching stop layer 404, thereby enabling the first electrode layer to come into contact with and be connected to the conductive portion 401.

In an example, a material of the first insulation layer 400 includes silicon oxide.

In other embodiments, the material of the first insulation layer 400 may alternatively be another insulating material, which is not limited herein.

Specifically, the conductive portion 401 is configured to be electrically connected to the subsequently formed first electrode column 428.

In an example, in a 1T1C (one transistor and one capacitor) memory, the conductive portion 401 may be used as a drain.

In other embodiments, the conductive portion 401 may alternatively be another film layer that is conductive, which is not further limited herein.

In an example, a material of the conductive portion 401 includes tungsten. In other embodiments, the material of the conductive portion may alternatively be another conductive material, which is not limited herein.

Specifically, the first etching stop layer 404 and the second etching stop layer 405 are made of the same material, the protective layer 409 is arranged between the first etching stop layer 404 and the second etching stop layer 405, so that the protective layer 409 protects the sidewall of the first etching stop layer 404 of the capacitor region 400A, thereby reducing the probability of the pickling solution contacting the first etching stop layer 404 in a subsequent pickling process. In this way, a probability of the first etching stop layer 404 of the capacitor region 400A being damaged is reduced, and a risk of collapse of the semiconductor structure due to damage to the first etching stop layer 404 of the capacitor region 400A is reduced, thereby improving the reliability of the semiconductor structure.

It should be noted that in the semiconductor structure forming method, the first etching stop layer 404 can stop etching in a process of forming the first electrode column 428, and the second etching stop layer 405 can stop etching in a process of forming the slit opening 430.

It should be further noted that the first etching stop layer 404 and the second etching stop layer 405 are obtained by patterning an etching stop material layer. Therefore, the first etching stop layer 404 and the second etching stop layer 405 are made of the same material. In a subsequent pickling process, the pickling solution can also chemically react with the first etching stop layer 404. By arranging the protective layer 409 between the first etching stop layer 404 and the second etching stop layer 405, even if the pickling solution removes the second etching stop layer 405, the protective layer 409 covers the side wall of the first etching stop layer 404, so that the protective layer 409 can prevent the pickling solution from contacting the first etching stop layer 404, thereby greatly reducing the probability of the first etching stop layer 404 being hollowed out, and further improving stability of the semiconductor structure of the capacitor region 400A.

Specifically, a top surface of the protective layer 409 is flush with the top surface of the first etching stop layer 404, so that the protective layer 409 can completely cover the first etching stop layer 404, reducing the probability of the first etching stop layer 404 contacting the pickling solution.

In this embodiment, the first etching stop layer 404 covers a surface of the capacitor region 400A of the substrate structure 402, so that the first etching stop layer 404 can stop etching during formation of the first electrode column 428.

In an example, when the first etching stop layer 404 and the second etching stop layer 405 are made of the same material, the material of the first etching stop layer 404 and the second etching stop layer 405 includes aluminum oxide.

Specifically, an etching selectivity ratio exists between the aluminum oxide and the material selected for the first stacked structure 410. In the step of forming the first electrode column 428, the aluminum oxide can stop etching. In addition, the aluminum oxide has a low dielectric constant and can reduce a signal delay and interference. Moreover, the aluminum oxide has good adhesion to a metal material, so that a stable interface can be formed between the aluminum oxide and the first electrode column 428.

In this embodiment, a material of the protective layer 409 is silicon oxide.

Specifically, the silicon oxide can protect the first etching stop layer 404. In a subsequent pickling process, the pickling solution is not easy to remove the silicon oxide, so that the silicon oxide can block the pickling solution.

In other embodiments, the material of the protective layer may alternatively be another acid-resistant material, which are not limited herein.

It should be noted that the first stacked structure 410 provides a process basis for subsequently setting a capacitor structure.

In this embodiment, the first stacked structure 410 includes silicon oxide layers 4101 and silicon nitride layers 4102 that are alternately deposited on the layer on which the first etching stop layer 404 and the second etching stop layer 405 are located, and an uppermost layer of the first stacked structure 410 is a silicon oxide layer 4101.

Specifically, after pickling is subsequently performed on the silicon nitride layer 4102, a capacitor dielectric layer and a second electrode layer are formed in space released by the silicon nitride layer 4102. Correspondingly, the silicon oxide layer 4101 electrically separates adjacent capacitor cell array layers. Moreover, the uppermost layer of the first stacked structure 410 is a silicon oxide layer 4101, so that the silicon oxide layer 4101 on the uppermost layer protects subsequently formed capacitors. In addition, a lowermost layer of the first stacked structure 410 is also the silicon oxide layer 4101, so that the silicon oxide layer 4101 on the lowermost layer can protect the top portion of the first etching stop layer 404, thereby reducing a probability of the pickling solution contacting the top portion of the first etching stop layer 404, and thus reducing a probability of the top portion of the first etching stop layer 404 being damaged.

Specifically, the first electrode column 428 can form a capacitor cell array layer together with the capacitor dielectric layer and the second electrode layer that are subsequently formed in the space released by the silicon nitride layer 4102.

In an example, a material of the first electrode column 428 includes tungsten. In other embodiments, the material of the first electrode column may alternatively be another electrode material, which is not limited herein.

It should be noted that in the present disclosure, after the first electrode column 428 is formed, the slit opening 430 is formed, and the formed first electrode column 428 can provide structural support for removing all the silicon nitride layers 4102 through pickling.

Specifically, the slit opening 430 provides a process window for removing the silicon nitride layer 4102 through pickling, so that the pickling solution can enter the silicon nitride layer 4102 through the slit opening 430, enabling the pickling solution to remove the silicon nitride layer 4102.

It should be noted that during formation of the slit opening 430, the second etching stop layer 405 is used as an etching stop position, so that a probability of the slit opening 430 extending through the substrate structure 402 can be reduced, and a risk of the slit opening 430 damaging a film layer below the substrate structure 402 can be reduced.

FIG. 8 is a schematic structural diagram corresponding to a second embodiment of a semiconductor structure according to the present disclosure.

Similarities between this embodiment of the present disclosure and the first embodiment are not repeated herein. A difference between this embodiment of the present disclosure and the first embodiment is as follows.

Referring to FIG. 8, a first etching stop layer 504 and a second etching stop layer 509 are made of different materials, a contact interface is formed between the first etching stop layer 504 and the second etching stop layer 509.

Specifically, the contact interface is formed between the first etching stop layer 504 and the second etching stop layer 509. In a subsequent process of performing pickling on a first stacked structure 510 through a slit opening 530, a pickling solution can also chemically react with the first etching stop layer 504. Since the first etching stop layer 504 and the second etching stop layer 509 are made of different materials, the second etching stop layer 509 in a logic region 500B protects a side wall of the first etching stop layer 504 in a capacitor region 500A and reduces a probability of the pickling solution contacting the first etching stop layer 504 in a subsequent pickling process, thereby reducing a probability of the first etching stop layer 504 of the capacitor region 500A being damaged.

In this embodiment, a material of the first etching stop layer 504 is aluminum oxide, and a material of the second etching stop layer 509 is amorphous silicon.

Specifically, an etching selectivity ratio exists between the aluminum oxide selected for the first etching stop layer 504 and a material selected for subsequently forming the first stacked structure 510. In a subsequent step of arranging the first electrode column 528, the aluminum oxide can stop etching. In addition, the aluminum oxide has a low dielectric constant and can reduce a signal delay and interference. Moreover, the aluminum oxide has good adhesion to a metal material, so that a stable interface can be formed between the aluminum oxide and the first electrode column 528.

It should be noted that the second etching stop layer 509 is made of the amorphous silicon. The amorphous silicon is an acid-resistant material and is not easily removed by pickling and wet etching, and can protect the first etching stop layer 504. In addition, an etching selectivity ratio exists between the amorphous silicon, and the silicon nitride layer and the silicon oxide layer, so that the second etching stop layer 509 can stop etching during formation of the slit opening 530.

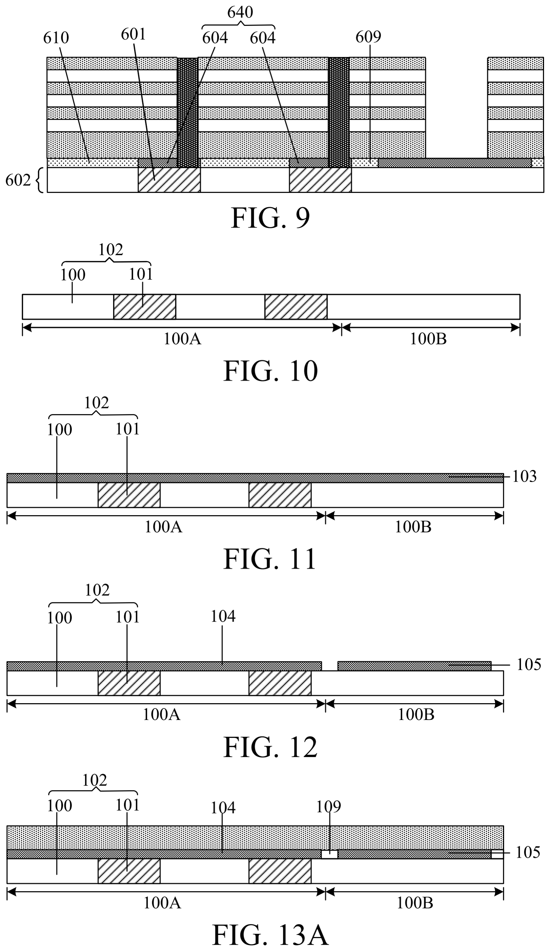

FIG. 9 is a schematic structural diagram corresponding to a third embodiment of a semiconductor structure according to the present disclosure.

Similarities between this embodiment of the present disclosure and the first embodiment are not repeated herein. A difference between this embodiment of the present disclosure and the first embodiment is as follows.

Referring to FIG. 9, a first etching stop layer 640 includes a plurality of first etching stop cell layers 604 that are arranged at intervals, and each first etching stop cell layer 604 covers a top portion of a corresponding conductive portion 601.

It should be noted that each first etching stop cell layer 604 correspondingly covers a top portion of a conductive portion 601, which means that in a method for forming a semiconductor structure, in a process of patterning to obtain the first etching stop layer 640, a photolithography mask plate of the conductive portion 601 may be formed by patterning, that is, a same photolithography mask plate is used to form the conductive portion 601 and the first etching stop layer 640, which can reduce a quantity of photolithography mask plates used and reduce a cost of using the photolithography mask plates.

In this embodiment, the semiconductor structure further includes: a second insulation layer 610, covering a top portion of a substrate structure 602 exposed by the plurality of first etching stop cell layers 604, where the second insulation layer 610 is flush with a top portion of the first etching stop layer 640, that is, the plurality of first etching stop cell layers 604 are inlaid at intervals in the second insulation layer 610.

In this embodiment, the second insulation layer 610 and the protective layer 609 are integrally formed.

Specifically, that the second insulation layer 610 and the protective layer 609 are integrally formed means that in the semiconductor structure forming method, the second insulation layer 610 and the protective layer 609 are formed in a same step. In other words, during formation of the second etching stop layer, an insulating material between the second etching stop layer and the first etching stop layer 640 is used as the protective layer 609, so that the protective layer 609 protects a side wall of the first etching stop layer 640 and reduces a risk of the first etching stop layer 640 being removed by a pickling solution.

In an example, a material of the second insulation layer 610 is silicon oxide.

Correspondingly, an embodiment of the present disclosure further provides a semiconductor structure forming method. FIG. 10 to FIG. 18 are schematic structural diagrams corresponding to steps of a first embodiment of a semiconductor structure forming method according to the present disclosure.

Referring to FIG. 10, a substrate structure 102 is provided, where the substrate structure 102 has a capacitor region 100A and a logic region 100B adjacent to the capacitor region 100A and includes a first insulation layer 100 and a plurality of conductive portions 101 inlaid at intervals in the first insulation layer 100, the conductive portions 101 are located in the capacitor region 10A, and a top surface of the conductive portion 101 is exposed from the first insulation layer 100.

Specifically, the substrate structure 102 provides a process platform for the subsequent semiconductor structure forming method.

In an example, the semiconductor structure is a capacitor structure.

In the capacitor structure, the capacitor region 100A is used as a region for storing data, and the logic region 100B is used as a region for controlling data read and write operations.

It should be noted that the first insulation layer 100 is configured to electrically separate adjacent conductive portions 101.

The first insulation layer 100 exposes the top surface of the conductive portion 101. During subsequent formation of the first electrode column, the first electrode column extends through the subsequently formed first stacked structure and the first etching stop layer, thereby enabling the first electrode layer to come into contact with and be connected to the conductive portion 101.

In an example, the material of the first insulation layer 100 is silicon oxide.

In other embodiments, the material of the first insulation layer 100 may alternatively be another insulating material, which is not limited herein.

Specifically, the conductive portion 101 is configured to be electrically connected to a subsequently formed first electrode column.

In an example, in a 1T1C (one transistor and one capacitor) memory, the conductive portion 101 may be used as a drain.

In other embodiments, the conductive portion 101 may alternatively be another film layer that is conductive, which is not further limited herein.

In an example, a material of the conductive portion 101 is tungsten.

Referring to FIG. 11 to FIG. 13B, an etching stop structure is formed on the substrate structure 102, where the etching stop structure includes: a first etching stop layer 104, covering an upper surface of the substrate structure 102 in the capacitor region 100A; and a second etching stop layer 105, located in the logic region 100B and covering a top portion of the first insulation layer 100, where the first etching stop layer 104 and the second etching stop layer 105 are in a same layer, and top surfaces of the first etching stop layer 104 and the second etching stop layer 105 are flush, where the first etching stop layer 104 and the second etching stop layer 105 are made of a same material, and the first etching stop layer 104 and the second etching stop layer 105 are separated by a protective layer 109.

Specifically, the first etching stop layer 104 and the second etching stop layer 105 are made of the same material, the protective layer 109 is arranged between the first etching stop layer 104 and the second etching stop layer 105, so that the protective layer 109 protects the sidewall of the first etching stop layer 104 of the capacitor region 100A, thereby reducing the probability of the pickling solution contacting the first etching stop layer 104 in a subsequent pickling process. In this way, a probability of the first etching stop layer 104 of the capacitor region 100A being damaged is reduced, and a risk of collapse of the semiconductor structure due to damage to the first etching stop layer 104 of the capacitor region 100A is reduced, thereby improving the reliability of the semiconductor structure.

In this embodiment, the step of forming an etching stop structure on the substrate structure 102 includes: as shown in FIG. 11, forming an etching stop material layer 103 covering an entire surface of the substrate structure 102; as shown in FIG. 12, patterning the etching stop material layer 103 to form the first etching stop layer 104 and the second etching stop layer 105 that are separated from each other, where the first etching stop layer 104 covers a surface of the capacitor region 100A of the substrate structure 102, and the second etching stop layer 105 covers a surface of the logic region 100B of the substrate structure 102; and as shown in FIG. 13A, filling a groove enclosed by the first etching stop layer 104 and the second etching stop layer 105 that are obtained through patterning with a protective material, and performing planarization, to form a protective layer 109, where the top surface of the protective layer 109 is flush with the top surfaces of the first etching stop layer 104 and the second etching stop layer 105, and the first etching stop layer 104 and the second etching stop layer 105 are separated by the protective layer 109.

In an example, the step of patterning the etching stop material layer 103 to form the first etching stop layer 104 and a second etching stop layer 105 that are separated from each other includes: removing the etching stop material layer 103 at a junction of the capacitor region 100A and the logic region 100B, using a remaining etching stop material layer 103 located in the capacitor region 100A as the first etching stop layer 104, and using a remaining etching stop material layer 103 located in the logic region 100B as the second etching stop layer 105.

In this implementation, the etching stop material layer 103 at the junction of the capacitor region 100A and the logic region 100B is removed by a selective etching process.

The first etching stop layer 104 can stop etching in a subsequent process of forming the first electrode column, and the second etching stop layer 105 can stop etching in a subsequent process of forming the slit opening.

It should be noted that the first etching stop layer 104 and the second etching stop layer 105 are obtained by patterning an etching stop material layer 103. Therefore, the first etching stop layer 104 and the second etching stop layer 105 are made of the same material. In a subsequent pickling process, the pickling solution can also chemically react with the first etching stop layer 104. By arranging the protective layer 109 between the first etching stop layer 104 and the second etching stop layer 105, even if the pickling solution removes the second etching stop layer 105, the protective layer 109 covers the side wall of the first etching stop layer 104, so that the protective layer 109 can prevent the pickling solution from contacting the first etching stop layer 104, thereby greatly reducing the probability of the first etching stop layer 104 being hollowed out, and further improving stability of the semiconductor structure of the capacitor region 100A.

In an example, a process of planarization includes a chemical mechanical grinding process.

In this embodiment, the material of the first etching stop layer 104 and the second etching stop layer 105 is aluminum oxide.

Specifically, an etching selectivity ratio exists between the aluminum oxide and the material selected for subsequently forming the first stacked structure. In the step of subsequently forming a first electrode column accommodating hole, the aluminum oxide can stop etching. In addition, the aluminum oxide has a low dielectric constant and can reduce a signal delay and interference. Moreover, the aluminum oxide has good adhesion to a metal material, so that a stable interface can be formed between the aluminum oxide and the first electrode column.

In this embodiment, a material of the protective layer 109 is silicon oxide.

Specifically, the silicon oxide can protect the first etching stop layer 104. In a subsequent pickling process, the pickling solution is not easy to remove the silicon oxide, so that the silicon oxide can block the pickling solution.

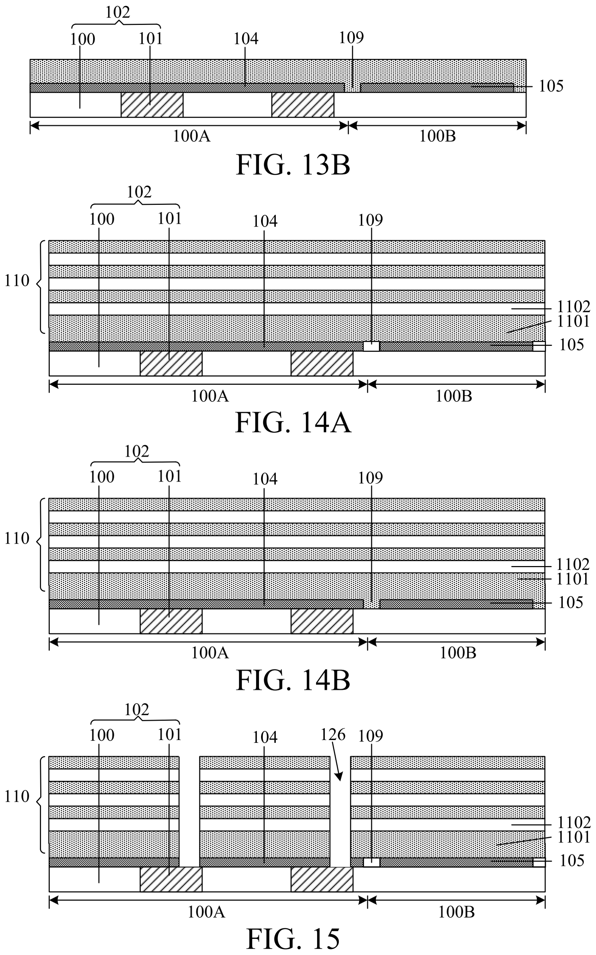

In this embodiment, as shown in FIG. 13B, the protective layer 109 and a first layer of silicon oxide layer 1101 in a subsequent formed first stacked structure are integrally formed.

Specifically, the protective layer 109 and the first layer of silicon oxide layer in the first stacked structure are integrally formed, which can reduce a deposition step for forming the first stacked structure and reduce a process cost.

In this embodiment, a groove enclosed by the first etching stop layer 104 and the second etching stop layer 105 that are obtained through patterning is filled with a protective material, and planarization is performed, to form a protective material layer, where the protective material layer includes the protective layer 109 and the first layer of silicon oxide layer 1101.

Continuing referring to FIG. 13A to FIG. 14B, a first stacked structure 110 is formed on the etching stop structure.

It should be noted that the first stacked structure 110 provides a process basis for subsequently forming a capacitor structure.

In an example, the first stacked structure 110 includes silicon oxide layers 1101 and silicon nitride layers 1102 that are alternately deposited on the etching stop structure, and an uppermost layer of the first stacked structure 110 is a silicon oxide layer 1101.

Specifically, after pickling is subsequently performed on the silicon nitride layer 1102, a capacitor dielectric layer and a second electrode layer are formed in space released by the silicon nitride layer 1102. Correspondingly, the silicon oxide layer 1101 electrically separates adjacent capacitor cell array layers. Moreover, the uppermost layer of the first stacked structure 110 is the silicon oxide layer 1101, so that the silicon oxide layer 1101 on the uppermost layer protects subsequently formed capacitors. In addition, a lowermost layer of the first stacked structure 110 is also the silicon oxide layer 1101, so that the silicon oxide layer 1101 on the lowermost layer can protect the top portion of the first etching stop layer 104, thereby reducing a probability of the pickling solution contacting the top portion of the first etching stop layer 104, and thus reducing a probability of the top portion of the first etching stop layer 104 being damaged.

In an example, a process for forming the first stacked structure 110 includes a thin film deposition process.

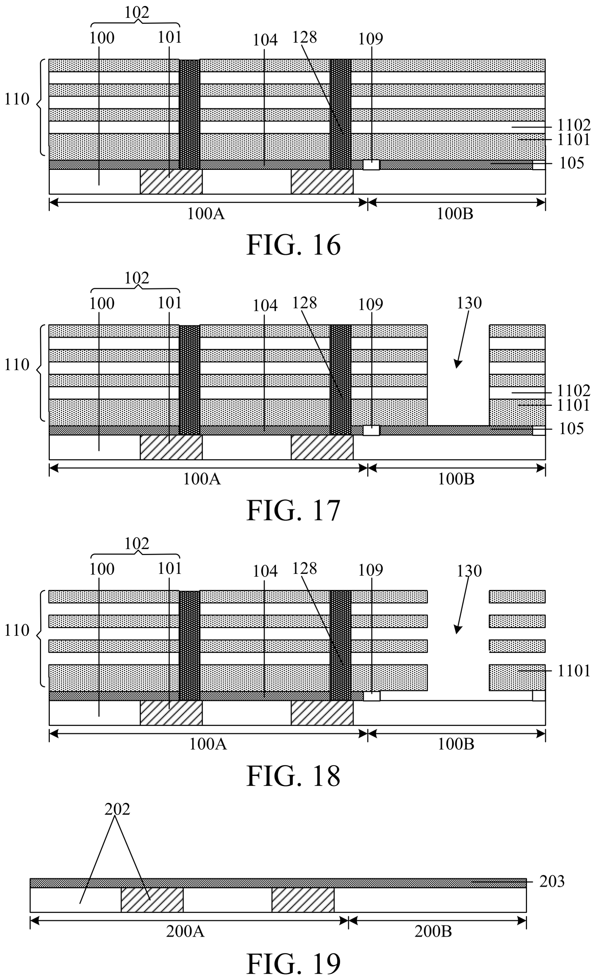

Referring to FIG. 15 and FIG. 16, a first electrode column accommodating hole 126 extending through the first stacked structure 110 and the first etching stop layer 104 is formed, and the first electrode column accommodating hole 126 exposes the conductive portion 101; and a first electrode column 128 is prepared in the first electrode column accommodating hole 126, where the first electrode column 128 is in contact with and connected to the conductive portion 101.

Specifically, the first electrode column 128 can form a capacitor structure together with the capacitor dielectric layer and the second electrode layer that are subsequently formed in the space released by the silicon nitride layer 1102.

In this embodiment, a process for forming the first electrode column accommodating hole 126 includes a dry etching process.

In this embodiment, after the first electrode column 128 is formed, a slit opening extending through the first stacked structure 110 is formed.

Referring to FIG. 17, a slit opening 130 extending through the first stacked structure 110 is formed, where the second etching stop layer 105 is exposed through the slit opening 130.

Specifically, the slit opening 130 provides a process window for removing the silicon nitride layer 1102 through pickling, so that the pickling solution can enter the silicon nitride layer 1102 through the slit opening 130, enabling the pickling solution to remove the silicon nitride layer 1102.

In this embodiment, the step of forming the slit opening 130 includes: using the second etching stop layer 105 as an etching stop position, patterning the first stacked structure 110, and forming the slit opening 130 extending through the first stacked structure 110 on the top portion of the second etching stop layer 105.

Specifically, the second etching stop layer 105 is used as the etching stop position, so that a probability of the slit opening 130 extending through the substrate structure 102 can be reduced, and a risk of the slit opening 130 damaging a film layer below the substrate structure 102 can be reduced.

In an example, a process for forming the slit opening 130 includes a dry etching process.

Referring to FIG. 18, after forming the slit opening 130, the forming method further includes: removing all silicon nitride layers 1102 in the first stacked structure 110 by pickling through the slit opening 130.

Specifically, removing the silicon nitride layer 1102 through pickling can release space occupied by the silicon nitride layer 1102, which is conducive to subsequent formation of a capacitor dielectric layer and a second electrode layer in the space released by the silicon nitride layer 1102, to form the capacitor structure.

In this embodiment, the method further includes partially or entirely removing the second etching stop layer 105 by pickling while removing all the silicon nitride layers 1102 in the first stacked structure 110 by pickling through the slit opening 130.

Specifically, the first etching stop layer and the second etching stop layer are made of the same material, the material of the first etching stop layer and the second etching stop layer includes aluminum oxide, and a pickling solution reacts with the aluminum oxide, so that the second etching stop layer 105 is partially or entirely removed.

In an example, in a process of performing pickling to remove all the silicon nitride layers 1102 in the first stacked structure 110, the pickling solution includes phosphoric acid.

FIG. 19 to FIG. 22 are schematic structural diagrams corresponding to steps of a second embodiment of a semiconductor structure forming method according to the present disclosure.

Similarities between this embodiment of the present disclosure and the first embodiment are not repeated herein. A difference between this embodiment of the present disclosure and the first embodiment is as follows.

Referring to FIG. 19 to FIG. 22, a first etching stop layer 204 and a second etching stop layer 209 are made of different materials, a contact interface is formed between the first etching stop layer 204 and the second etching stop layer 209.

Specifically, the contact interface is formed between the first etching stop layer 204 and the second etching stop layer 209. In a subsequent process of performing pickling on a first stacked structure through a slit opening, a pickling solution can also chemically react with the first etching stop layer 204. Since the first etching stop layer 204 and the second etching stop layer 209 are made of different materials, the second etching stop layer 209 protects a side wall of the first etching stop layer 204 in a capacitor region 200A and reduces a probability of the pickling solution contacting the first etching stop layer 204 in a subsequent pickling process, thereby reducing a probability of the first etching stop layer 204 of the capacitor region 200A being damaged.

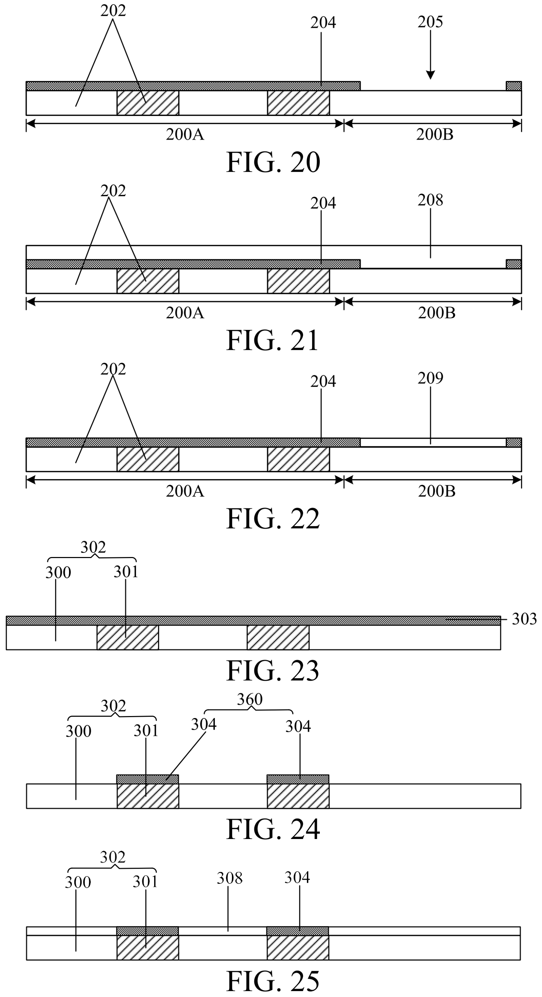

In an example, the step of forming an etching stop structure on the substrate structure 202 includes: as shown in FIG. 19, forming an etching stop material layer 203 covering an entire surface of the substrate structure 202; as shown in FIG. 20, patterning the etching stop material layer 203 to form the first etching stop layer 204 and a second etching stop layer accommodating slot 205 that are separated from each other; and as shown in FIG. 21 and FIG. 22, filling the second etching stop layer accommodating slot 205 with a second etching stop material layer 208 and performing surface planarization, to form the second etching stop layer 209, where the first etching stop layer 204 and the second etching stop layer 209 are made of different materials, a contact interface is formed between the first etching stop layer 204 and the second etching stop layer 209.

Specifically, the second etching stop layer accommodating slot 205 provides a spatial position for filling the second etching stop layer 209.

In this embodiment, the step of forming the first etching stop layer 204 and the second etching stop layer accommodating slot 205 includes: forming a patterned mask layer on a top portion of the etching stop material layer 203, where the mask layer exposes a top surface of the etching stop material layer 203 in a logic region 200B; and using the mask layer as a mask, patterning the etching stop material layer 203, to remove the etching stop material layer 203 in the logic region 200B, forming the second etching stop layer accommodating slot 205 in the logic region 200B, and using a remaining etching stop material layer 203 in the capacitor region 200A as the first etching stop layer 204.

In this embodiment, the step of performing surface planarization on the second etching stop material layer 208 includes: using a top surface of the first etching stop layer 204 as a stop position, performing planarization on the second etching stop material layer 208 higher than the top surface of the first etching stop layer 204.

In this embodiment, a material of the first etching stop layer 204 includes aluminum oxide, and a material of the second etching stop layer 209 includes amorphous silicon.

Specifically, an etching selectivity ratio exists between the aluminum oxide selected for the first etching stop layer 204 and a material selected for subsequently forming the first stacked structure. In a subsequent step of forming the first electrode column accommodating hole, the aluminum oxide can stop etching. In addition, the aluminum oxide has a low dielectric constant and can reduce a signal delay and interference. Moreover, the aluminum oxide has good adhesion to a metal material, so that a stable interface can be formed between the aluminum oxide and the first electrode column.

It should be noted that the second etching stop layer 209 is made of pickling-resistant amorphous silicon, which can protect the first etching stop layer 204 in a subsequent pickling process. In addition, an etching selectivity ratio exists between the amorphous silicon, and the silicon nitride layer and the silicon oxide layer, so that the second etching stop layer 209 can stop etching during the formation of the slit opening.

FIG. 23 to FIG. 27 are schematic structural diagrams corresponding to steps of a third embodiment of a semiconductor structure forming method according to the present disclosure.

Similarities between this embodiment of the present disclosure and the first embodiment are not repeated herein. A difference between this embodiment of the present disclosure and the first embodiment is as follows.

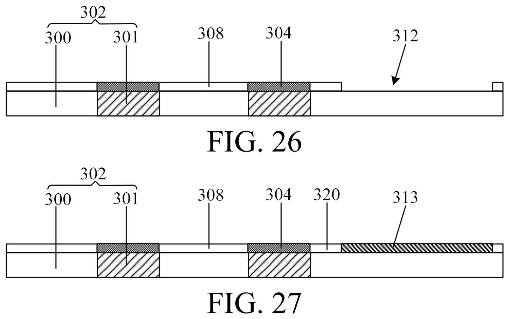

Referring to FIG. 23 to FIG. 27, the forming an etching stop structure on the substrate structure 302 includes the following steps: as shown in FIG. 23, forming an etching stop material layer 303 covering an entire surface of the substrate structure 302; as shown in FIG. 24, patterning the etching stop material layer 303 to form the first etching stop layer 360, where the first etching stop layer 360 includes a plurality of first etching stop cell layers 304, and each first etching stop cell layer 304 correspondingly covers a top portion of one conductive portion 301; as shown in FIG. 25, filling a separating groove between the plurality of first etching stop cell layers 304 that are obtained through patterning with a second insulating material layer and performing surface planarization to form a second insulation layer 308, where a top surface of the second insulation layer 308 is flush with a top surface of the first etching stop layer 360; as shown in FIG. 26, forming a second etching stop layer accommodating slot 312 extending through the second insulation layer 308; and as shown in FIG. 27, filling the second etching stop layer accommodating slot 312 with a second etching stop material layer 303 and performing surface planarization, to perform the second etching stop layer 313, where a second insulating material layer between the second etching stop layer 313 and the first etching stop layer 360 is used as the protective layer 320, where the first etching stop layer 360 and the second etching stop layer 313 are made of a same material.

It should be noted that each first etching stop cell layer 304 correspondingly covers a top portion of a conductive portion 301, which means that in a process of patterning the etching stop material layer 303 to form the first etching stop layer 360, a photolithography mask plate of the conductive portion 301 may be formed through patterning. That is, the conductive portion 301 and the first etching stop layer 360 are formed by using a same photolithography mask plate, which can reduce a quantity of photolithography mask plate and reduce a cost of using the photolithography mask plates.

Specifically, the second insulation layer 308 is configured to electrically separate adjacent first etching stop cell layers 304, to reduce a risk of electricity leakage between the adjacent first etching stop cell layers 304.

The second insulation layer 308 covers a top portion of the first insulation layer 300 in the capacitor region.

The second etching stop layer accommodating slot 312 provides a spatial position for forming the second etching stop layer 313.

It should be noted that during formation of the second etching stop layer 313, the second insulating material layer between the second etching stop layer 313 and the first etching stop layer 360 is used as the protective layer 320, so that the protective layer 320 protects a side wall of the first etching stop layer 360 and reduces a risk of the first etching stop layer 360 being removed by a pickling solution.

In an example, a material of the second insulation layer 308 includes silicon oxide.

## Claims

1. A semiconductor structure, comprising:
a substrate structure(402, 602), wherein the substrate structure(402, 602) has a capacitor region(400A, 500A) and a logic region(400B, 500B) adjacent to the capacitor region(400A, 500A), the capacitor region(400A, 500A) and the logic region(400B, 500B) are used as a capacitor cell array region, and the substrate structure(402, 602) comprises a first insulation layer(400) and a plurality of conductive portions(401, 601) inlaid at intervals in the first insulation layer(400), wherein the conductive portions(401, 601) are located in the capacitor region(400A, 500A), and a top surface of the conductive portion(401, 601) is exposed from the first insulation layer(400);
a first etching stop layer(404, 504, 640), located in the capacitor region(400A, 500A) and at least covering a top portion of the conductive portion(401, 601);
a second etching stop layer(405, 509), located in the logic region(400B, 500B) and covering a top portion of the first insulation layer(400), wherein the second etching stop layer(405, 509) and the first etching stop layer(404, 504, 640) are located in a same layer, and top surfaces of the second etching stop layer(405, 509) and the first etching stop layer(404, 504, 640) are flush;
a first stacked structure(410, 510), covering a layer in which the first etching stop layer(404, 504, 640) and the second etching stop layer(405, 509) are located;
a plurality of first electrode columns(428, 528), wherein each first electrode column(428, 528) extends through the first stacked structure(410, 510) and the first etching stop layer(404, 504, 640) and is in contact with and connected to a corresponding one of the conductive portions(401, 601); and
a slit opening(430, 530), extending through the first stacked structure(410, 510) exposing the second etching stop layer(405, 509); wherein
the first etching stop layer(404, 504, 640) and the second etching stop layer(405, 509) are made of a same material, and the first etching stop layer(404, 504, 640) and the second etching stop layer(405, 509) are separated by a protective layer(409, 609) such that the protective layer(409, 609) protects a side wall of the first etching stop layer(404, 504, 640) in a process of performing pickling on a first stacked structure(410, 510) through the slit opening(430, 530); or the first etching stop layer(404, 504, 640) and the second etching stop layer(405, 509) are made of different materials, and a contact interface is formed between the first etching stop layer(404, 504, 640) and the second etching stop layer(405, 509) such that the second etching stop layer(405, 509) protects a side wall of the first etching stop layer(404, 504, 640) in a process of performing pickling on a first stacked structure(410, 510) through the slit opening(430, 530).

2. The semiconductor structure according to claim 1, wherein the first stacked structure(410, 510) comprises silicon oxide layers(4101) and silicon nitride layers(4102) that are alternately deposited on the layer on which the first etching stop layer(404, 504, 640) and the second etching stop layer(405, 509) are located, and an uppermost layer of the first stacked structure(410, 510) is a silicon oxide layer(4101).

3. The semiconductor structure according to claim 1, wherein the first etching stop layer(404, 504, 640) and the second etching stop layer(405, 509) are made of the same material, the material of the first etching stop layer(404, 504, 640) and the second etching stop layer(405, 509) comprises aluminum oxide, and a material of the protective layer(409, 609) comprises silicon oxide.

4. The semiconductor structure according to claim 1, wherein the first etching stop layer(404, 504, 640) and the second etching stop layer(405, 509) are made of the different materials, the material of the first etching stop layer(404, 504, 640) comprises aluminum oxide, and the material of the second etching stop layer(405, 509) comprises amorphous silicon.

5. The semiconductor structure according to claim 1, wherein the first etching stop layer(404, 504, 640) covers a surface of the capacitor region(400A, 500A) of the substrate structure(402, 602).

6. The semiconductor structure according to claim 1, wherein the first etching stop layer(404, 504, 640) comprises a plurality of first etching stop cell layers(604) that are arranged at intervals, and each first etching stop cell layer(604) covers a top portion of the corresponding conductive portion(401, 601); and
the semiconductor structure further comprises: a second insulation layer(610), covering a top portion of the substrate structure(402, 602) exposed by the plurality of first etching stop cell layers(604), wherein the second insulation layer(610) is flush with a top portion of the first etching stop layer(404, 504, 640), that is, the plurality of first etching stop cell layers(604) are inlaid at intervals in the second insulation layer(610).

7. The semiconductor structure according to claim 6, wherein the second insulation layer(610) and the protective layer(409, 609) are integrally formed; and
a material of the second insulation layer(610) comprises silicon oxide.

8. A semiconductor structure forming method, comprising:
providing a substrate structure(102, 202, 302), wherein the substrate structure(102, 202, 302) has a capacitor region(100A, 200A) and a logic region(100B, 200B) adjacent to the capacitor region(100A, 200A), the capacitor region(100A, 200A) and the logic region(100B, 200B) are used as a capacitor cell array region, and the substrate structure(102, 202, 302) comprises a first insulation layer(100, 300) and a plurality of conductive portions(101, 301) inlaid at intervals in the first insulation layer(100, 300), the conductive portions(101, 301) are located in the capacitor region(100A, 200A), and a top surface of the conductive portion(101, 301) is exposed from the first insulation layer(100, 300);
forming an etching stop structure on the substrate structure(102, 202, 302), wherein the etching stop structure comprises:
a first etching stop layer(104, 204, 360), located in the capacitor region(100A, 200A) and at least covering a top portion of the conductive portion(101, 301); and
a second etching stop layer(105, 209, 313), located in the logic region(100B, 200B) and covering a top portion of the first insulation layer(100, 300), wherein the first etching stop layer(104, 204, 360) and the second etching stop layer(105, 209, 313) are located in a same layer, and top surfaces of the first etching stop layer(104, 204, 360) and the second etching stop layer(105, 209, 313) are flush;
forming a first stacked structure(110) on the etching stop structure;
forming a plurality of first electrode column accommodating holes(126) extending through the first stacked structure(110), wherein the first electrode column accommodating hole(126) exposes the conductive portion(101, 301);
preparing a first electrode column(128) in the first electrode column accommodating hole(126), wherein each of the first electrode columns(128) is in contact with and connected to a corresponding one of the conductive portions(101, 301); and
forming a slit opening(130) extending through the first stacked structure(110), wherein the second etching stop layer(105, 209, 313) is exposed from the slit opening(130); wherein
the first etching stop layer(104, 204, 360) and the second etching stop layer(105, 209, 313) are made of a same material, and the first etching stop layer(104, 204, 360) and the second etching stop layer(105, 209, 313) are separated by a protective layer(109, 320) such that the protective layer(109, 320) protects a side wall of the first etching stop layer(104, 204, 360) in a process of performing pickling on a first stacked structure(110) through the slit opening(130); or the first etching stop layer(104, 204, 360) and the second etching stop layer(105, 209, 313) are made of different materials, and a contact interface is formed between the first etching stop layer(104, 204, 360) and the second etching stop layer(105, 209, 313) such that the second etching stop layer(105, 209, 313) protects a side wall of the first etching stop layer(104, 204, 360) in a process of performing pickling on a first stacked structure(110) through the slit opening(130).

9. The semiconductor structure forming method according to claim 8, wherein the step of forming an etching stop structure on the substrate structure(102, 202, 302) comprises:
forming an etching stop material layer(103, 203, 303) covering an entire surface of the substrate structure(102, 202, 302);
patterning the etching stop material layer(103, 203, 303) to form the first etching stop layer(104, 204, 360) and the second etching stop layer(105, 209, 313) that are separated from each other, wherein the first etching stop layer(104, 204, 360) covers a surface of the capacitor region(100A, 200A) of the substrate structure(102, 202, 302), and the second etching stop layer(105, 209, 313) covers a surface of the logic region(100B, 200B) of the substrate structure(102, 202, 302); and
filling a groove enclosed by the first etching stop layer(104, 204, 360) and the second etching stop layer(105, 209, 313) that are obtained through patterning with a protective material, and performing planarization, to form a protective layer(109, 320), wherein the top surface of the protective layer(109, 320) is flush with the top surfaces of the first etching stop layer(104, 204, 360) and the second etching stop layer(105, 209, 313), and the first etching stop layer(104, 204, 360) and the second etching stop layer(105, 209, 313) are separated by the protective layer(109, 320).

10. The semiconductor structure forming method according to claim 9, wherein the first stacked structure(110) comprises silicon oxide layers(1101) and silicon nitride layers(1102) that are alternately and cyclically deposited on the etching stop structure, the material of the protective layer(109, 320) is silicon oxide, the protective layer(109, 320) and a first layer of silicon oxide layer(1101) in the first stacked structure(110) are integrally formed, and the forming method comprises:
filling the groove enclosed by the first etching stop layer(104, 204, 360) and the second etching stop layer(105, 209, 313) that are obtained through patterning with a protective material, and performing planarization, to form a protective material layer, wherein the protective material layer comprises the protective layer(109, 320) and the first layer of silicon oxide layer(1101).

11. The semiconductor structure forming method according to claim 8, wherein the step of forming an etching stop structure on the substrate structure(102, 202, 302) comprises:
forming an etching stop material layer(103, 203, 303) covering an entire surface of the substrate structure(102, 202, 302);
patterning the etching stop material layer(103, 203, 303) to form the first etching stop layer(104, 204, 360) and a second etching stop layer accommodating slot(205, 312) that are separated from each other; and
filling the second etching stop layer accommodating slot(205, 312) with a second etching stop material layer(208, 303) and performing surface planarization, to form the second etching stop layer(105, 209, 313), wherein
the first etching stop layer(104, 204, 360) and the second etching stop layer(105, 209, 313) are made of different materials, and a contact interface is formed between the first etching stop layer(104, 204, 360) and second etching stop layer(105, 209, 313).

12. The semiconductor structure forming method according to claim 8, wherein the forming an etching stop structure on the substrate structure(102, 202, 302) comprises the following steps:
forming an etching stop material layer(103, 203, 303) covering an entire surface of the substrate structure(102, 202, 302);
patterning the etching stop material layer(103, 203, 303) to form the first etching stop layer(104, 204, 360), wherein the first etching stop layer(104, 204, 360) comprises a plurality of first etching stop cell layers(304), and each etching stop cell layer(304) correspondingly covers a top portion of one conductive portion(101, 301);
filling a separating groove between the plurality of first etching stop cell layers(304) that are obtained through patterning with a second insulating material layer, and performing surface planarization, to form a second insulation layer(308), wherein a top surface of the second insulation layer(308) is flush with a top surface of the first etching stop layer(104, 204, 360);
forming a second etching stop layer accommodating slot(205, 312) extending through the second insulation layer(308); and
filling the second etching stop layer accommodating slot(205, 312) with a second etching stop material layer(208, 303) and performing surface planarization, to perform the second etching stop layer(105, 209, 313), wherein a second insulating material layer between the second etching stop layer(105, 209, 313) and the first etching stop layer(104, 204, 360) is used as the protective layer(109, 320), wherein
the first etching stop layer(104, 204, 360) and the second etching stop layer(105, 209, 313) are made of a same material.

13. The semiconductor structure forming method according to claim 8, wherein the first stacked structure(110) comprises silicon oxide layers(1101) and silicon nitride layers(1102) that are alternately deposited on the etching stop structure, and an uppermost layer of the first stacked structure(110) is a silicon oxide layer(1101); and
after forming the slit opening( 130), the forming method further comprises: removing all silicon nitride layers(1102) in the first stacked structure(110) by pickling through the slit opening(130).

14. The semiconductor structure forming method according to claim 13, wherein the first etching stop layer(104, 204, 360) and the second etching stop layer(105, 209, 313) are made of the same material, the material of the first etching stop layer(104, 204, 360) and the second etching stop layer(105, 209, 313) comprises aluminum oxide, and a material of the protective layer(109, 320) comprises silicon oxide; and
the method further comprises partially or entirely removing the second etching stop layer(105, 209, 313) by pickling while removing all the silicon nitride layers(1102) in the first stacked structure(110) by pickling through the slit opening(130).
